# EUROPÄISCHE PATENTSCHRIFT

(11) **EP 2 869 095 B1**
(45) Veröffentlichungstag und Bekanntmachung des Hinweises auf die Patenterteilung: **07.12.2016**
(21) Anmeldenummer: 13190692.7
(22) Anmeldetag: 29.10.2013
(51) Int. Cl.: G01V 8/20

(54) **Optoelektronischer Sensor**
Optoelectronic sensor
Capteur optoélectronique

(43) Veröffentlichungstag der Anmeldung: 06.05.2015
(73) Patentinhaber: SICK AG, 79183 Waldkirch (DE)
(72) Erfinder: Eble, Johannes, 79183 Waldkirch (DE); Matt, Sebastian, 77796 Mühlenbach (DE); Alt, Gerhard, 79350 Sexau (DE); Bürger, Jürgen, 79331 Nimburg (DE)
(74) Vertreter: Ludewigt, Christoph

(56) Entgegenhaltungen:
- EP-A1- 2 209 165
- DE-U1-202008 002 116
- US-A1- 2003 103 347
- US-A1- 2010 053 956

## Beschreibung

Die Erfindung betrifft einen optoelektronischen Sensor, insbesondere ein Lichtgitter, mit wenigstens zwei in einer Längsrichtung hintereinander anzuordnenden Elektronikkarten, auf denen mehrere Lichtsender und/oder Lichtempfänger in Reihe angeordnet sind, wobei die Elektronikkarten durch ein Funktionselement in Sollposition zueinander fixiert sind und die Elektronikkarten in einem Gehäuse gehalten sind.

Derartige Lichtgitter bestehen in der Regel aus einer Sendeleiste, also einem länglichen Gehäuse, in dem Lichtsender in Reihe angeordnet sind und einer Empfangsleiste, in der eine der Senderzahl entsprechende Anzahl Lichtempfänger in Reihe angeordnet sind, so dass jeweils ein Lichtsender und ein Lichtempfänger einander zugeordnet sind. Die Lichtsender und Lichtempfänger müssen nicht zwingend getrennt in verschiedenen Gehäusen angeordnet sein. Es sind auch Lichtgitter bekannt, bei dem in einem Gehäuse sowohl Lichtsender als auch Lichtempfänger angeordnet sind.

Derartige Lichtgitter werden sehr vielseitig eingesetzt. Dies bedingt eine sehr hohe Flexibilität im Aufbau ("Baukastensystem"), was wiederum zu technisch extremen Herausforderungen führt. Um hohe Systemperformance bei den unterschiedlichsten Ausprägungen des Lichtgitters zu erhalten, ergeben sich vielseitige Problemstellungen.

Die Sende- und Empfangseinheiten, also Lichtsender mit eventueller Sendeoptik (Optikmodul) und Lichtempfänger mit eventueller Empfangsoptik, müssen möglichst exakt relativ zum Gehäuse positioniert werden, denn die Exaktheit der Positionierung wirkt sich auf den Abstrahl- bzw. den Empfangswinkel aus und damit korreliert sie direkt mit der Systemperformance in Bezug auf beispielsweise Reichweite oder Schielwinkel zwischen den Sende- oder Empfangselementen. Die Sende- und Empfangseinheiten sind in der Regel auf Elektronikkarten angeordnet (aufgelötet), so dass zur genauen Positionierung die Elektronikkarten und die Optikmodule mit möglichst wenig Toleranz mit dem Gehäuse verbunden werden sollten.

Eine unterschiedliche Anzahl von Elektronikkarten oder Optikmodulen muss aneinandergehängt werden, denn es werden Lichtgitter in unterschiedlichen Längen benötigt und hergestellt (unterschiedliche Überwachungsfeldgröße). Je nach Gerätelänge werden mehrere Sende- bzw. Empfangsmodule (E-Karte + Optikmodule) miteinander verbunden und in ein entsprechendes Gehäuse eingeschoben.

Da solche Lichtgitter zuweilen eine erhebliche Länge, z. B. mehr als einen Meter, aufweisen, müssen diese Elektronikkarten fest zueinander fixiert werden, damit sich die Elektronikkarten nicht relativ zueinander verschieben können.

Um insbesondere bei langen Lichtgittern eine Justierung der Lichtsender und Lichtempfänger im Betrieb beizubehalten, wird bei bekannten Lichtgittern die Sende- bzw. Empfangseinheitskette über die Optikmodule im Profil geführt. Eine solche bekannte Führung ist aber nicht möglich, wenn die Möglichkeit offengehalten werden soll, z. B. aus Kostengründen oder um die Mehrfachkreuzstrahltechnik zu verwenden, auf die Optikmodule zu verzichten.

Es bietet sich dann nur die Möglichkeit, die Elektronikkarten selbst (und nicht die Optikmodule) im Gehäuse zu halten. Dabei muss die Genauigkeit in der Strahlausrichtung und im Strahlraster, also Abstand der Lichtstrahlen zueinander, trotz hoher Toleranz in Dicke und Breite der Elektronikkarten gewährleistet werden. Das ist wichtig, denn die Exaktheit des Strahlrasters bestimmt die Systemperformance bezüglich Genauigkeit von Höhenmessungen über die Anzahl unterbrochener Lichtstrahlen. Besonders bei kleinen Strahlrastern (z. B. Rasterabstand 2,5mm) hat die Toleranz von Elektronikkarte zu Elektronikkarte erheblichen (störenden) Einfluss. Diesbezüglich ist aus der EP 2 090 906 A2 bekannt, benachbarte Elektronikkarten über Kunststoffverbindungselemente, die gleichzeitig die elektronische Verbindung herstellen, zueinander lagefixiert zu verbinden.

Die US 2003/103347 offenbart eine Sprungfeder als Verbindungselement zwischen den Elektronikkarten. Damit wird zwar eine Fixierung der Elektronikkarten zwischen den Gehäusewänden erreicht, jedoch findet diese Fixierung nicht an den Nutwänden bzw. Nutböden statt. Durch die federelastischen Elemente wie beansprucht innerhalb der Nuten wird eine Verbesserung der Lagefestigkeit erreicht was eine Verbesserung der Genauigkeit in der Strahlausrichtung bewirkt. Weiterhin dient die Sprungfeder in erster Linie der elektrischen Verbindung zwischen den Elektronikarten.

Auch Temperaturänderungen stellen ein großes Problem dar. Das Gehäuse besteht üblicherweise aus einem Aluminiumprofil. Die verschiedenen Bauteile (FR4 für die Elektronikkarte und Aluminium für das Gehäuse sowie Kunststoff für sonstige Bauteile) unterscheiden sich in ihren Materialeigenschaften (Längenausdehnungskoeffizient). Bei langen Geräten und/oder großen Temperaturunterschieden kommt es zu großen Änderungen, es können Spannungen im Gerät entstehen bzw. die Sende-/Empfangsmodule können sich relativ zum Gehäuse verschieben. Dies kann die Systemperformance beeinträchtigen bzw. zu Montageproblemen führen. Damit das Gerät über einen großen Temperaturbereich einsetzbar ist, muss möglichst gut dafür gesorgt werden, dass die Ausdehnung der Elektronikkartenkette relativ zum Gehäuse möglichst gering ist.

Ein weiteres Problemfeld stellt die Montage derartiger Lichtgitter dar. Die Elektronikkarten sind zumeist in gegenüberliegenden Nuten im Profilgehäuse gehalten. Insbesondere bei langen Geräten, die bis zu einer Länge von mehreren Metern aufgebaut werden, führen große Toleranzen der Elektronikkarten bezüglich Dicke und Breite zu erhöhten Einschiebekräften (Verkippen und Verkanten der Elektronikkarten im Profil), was den Aufbau erheblich erschwert. Idealerweise sollte die Kraft, die zum Einschieben der Kette in das Gehäuse aufgewendet werden muss, minimal sein. Weitere Belastungen, denen ein Lichtgitter ausgesetzt ist, sind Schwing- und Schockbelastungen, die insbesondere dann störend wirken, wenn zwischen den einzelnen Komponenten ein Spiel besteht. Es kommt nicht nur zu Einbußen in der Systemperformance, sondern es können auch Teile zerstört werden. Es ist deshalb wünschenswert, die Elektronikkartenkette möglichst spielfrei im Gehäuse zu halten.

Aus der DE 20 2008 002 116 U1 ist ein Sensor nach dem Oberbegriff des Anspruchs 1 bekannt. Aus der US 2003/0103347 A1 ist ein elektrisches Verbindungselement für Leiterplatten eines Lichtgitters bekannt, das sich federnd an einer Gehäusewand abstützt.

Ausgehend von diesem Stand der Technik ist es Aufgabe der Erfindung einen verbesserten optoelektronischen Sensor, insbesondere ein Lichtgitter, bereitzustellen, mit dem möglichst viele der vorgenannten Probleme vorteilhaft lösbar oder zumindest reduzierbar sind.

Diese Aufgabe wird gelöst durch einen Sensor mit den Merkmalen des Anspruchs 1.

Der erfindungsgemäße optoelektronische Sensor ist insbesondere ein Lichtgitter. Er umfasst wenigstens zwei in einer Längsrichtung (z-Richtung) hintereinander anzuordnenden Elektronikkarten, auf denen mehrere Lichtsender und/oder Lichtempfänger in Reihe angeordnet sind, wobei die Elektronikkarten durch ein Funktionselement in Sollposition zueinander fixiert sind und die Elektronikkarten in einem Gehäuse gehalten sind. Erfindungsgemäß ist das Gehäuse als Profil ausgebildet und die Elektronikkarten sind in in Längsrichtung (z-Richtung) verlaufenden, gegenüberliegenden Nuten des Profils über die Funktionselemente gehalten, so dass die Funktionselemente die Elektronikkarten senkrecht (in x-y Ebene) zur Längsrichtung lagefest positionieren.

Die exakte Positionierung und Fixierung der Sender und/oder Empfänger erfolgt jetzt nicht mehr über die Elektronikkarten alleine oder über mit der Elektronikkarte verbundene Optikmodule, sondern über die Funktionselemente. Dazu sollte jede Elektronikkarte bevorzugt an beiden Enden über ein solches Funktionselement gehalten sein. Es versteht sich, dass dazu die auf den Elektronikkarten angeordneten Sende- und Empfangselemente eine genau definierte Position haben und damit letztendlich auch zu den Funktionselementen genau definiert positiniert sind. Die Lichtstrahlen sind damit optimal justiert und haben exakte Verfügbarkeitswinkel und minimale Schielwinkel.

Ein Lichtgitter mit einer solchen Halterung bietet eine Reihe Vorteile bzw. löst eine Reihe der genannten Probleme.

Da die Elektronikkartenkette über die Funktionselemente und nicht über Optikmodule im Profil geführt ist, kann für gewünschte Systemvarianten auf die Optikmodule verzichtet werden. Dies ermöglicht, kostengünstigere Lichtgittervarianten oder Varianten mit verbesserter Kreuzstrahlperformance bereitzustellen.

Dabei ist eine genaue Ausrichtung und Positionierung der Sende/ Empfangsmodule relativ zum Gehäuse in x, y und z-Richtung gewährleistet, wobei die vorhandenen Toleranzen in den Elektronikkarten und im Gehäuseprofil "aufgefangen" werden.

Die Temperaturabhängigkeit und damit die relative Längenausdehnung von Gehäuse und Elektronikartenkette kann über das Temperaturverhalten der die Elektronikkarten verbindenden Funktionselemente so "eingestellt" werden, dass möglichst wenig relative Änderung der gesamten Kette gegenüber dem Gehäuse auftritt.

Da die Kette mit den Elektronikkarten und deren Funktionselementen nur punktuell, nämlich über die Funktionselemente, in der Nut gehalten ist, ist vorteilhaft eine geringe Einschiebekraft beim Einführen der Kette in das Profil notwendig. Dabei wird eine hohe Positionsgenauigkeit von Elektronikkarte zu Elektronikkarte und damit ein genaues Strahlraster erhalten. Dabei ist es vorteilhaft, wenn die Funktionselemente in Längsrichtung möglichst kurz im Vergleich zu den Elektronikkarten sind.

Für die möglichst genaue Positionierung der Sende- und Empfangselemente in Relation zum Gehäuse und von Elektronikkarte zu Elektronikkarte ist in Weiterbildung der Erfindung vorgesehen, dass das Funktionselement flächig ausgebildet ist und flächig an den Elektronikkarten anliegt und dass erste und zweite, von einer der Flachseiten abstehende Referenzzapfen vorgesehen sind zur lagefesten Verbindung des Funktionselements mit den Elektronikkarten. Dabei werden bei der Verbindung die Referenzzapfen bevorzugt in erste und zweite Referenzbohrungen der Elektronikkarten eingesetzt. Die Sende- und Empfangselemente sind in Bezug auf die Referenzbohrungen genau definiert positioniert, damit letztendlich ein Rastermaß, also der Abstand der Lichtstrahlen des Lichtgitters, über die volle Länge des Lichtgitters genau eingehalten ist.

Die Robustheit des erfindungsgemäßen Systems gegenüber Schwing- und Schockbelastungen ist erhöht, denn die Elektronikkarten sind fest in den Nuten über die Funktionselemente quer zur Längsrichtung, also in der in x-y-Ebene gehalten. Dies gilt insbesondere wenn das Funktionselement wenigstens ein erstes Federelement und wenigstens ein zweites Federelement aufweist, so dass das Funktionselement durch federelastische Anlage zwischen Nutwänden einerseits und Nutböden andererseits senkrecht zur Längsrichtung fixiert, aber in Längsrichtung verschiebbar gehalten ist. Damit ist eine völlig spielfreie und damit entsprechend schockresistente Halterung möglich, die aber gleichzeitig noch ein Einführen der Elektronikkartenkette in die Nuten mit geringer Einschiebekraft erlaubt.

Die erfindungsgemäßen Funktionselemente erlauben eine davon gesonderte elektrische Verbindung benachbarter Elektronikkarten. Dies hat den Vorteil, dass die elektrische Kontaktierung frei von mechanischen Anforderungen ist. Es reichen einfache Kontaktstifte, die in entsprechende Buchsen geradlinig einführbar sind und keine aufwändige, kostenträchtige mechanische Verriegelung benötigen. Die elektrische Verbindung ist damit immer sichergestellt und die Elektronikkarten und damit die elektrischen Verbindungen können sich nicht durch Temperaturausdehnungen oder Schock auseinanderbewegen.

Die oben erwähnten Federelemente können in verschiedenen Ausführungen ausgeführt sein. Die Federelemente können durch Bögen gebildet sein, deren Enden mit dem Funktionselement verbunden sind und deren ausgewölbte Mitte sich gegen Nutboden oder Nutwand abstützt. Oder die Federelemente können mit einseitiger Aufhängung ausgeführt werden und so wie ein Federarm ausgeführt sein, dessen freies Ende sich am Nutboden bzw. Nutwand abstützt.

In einer Alternative können die Federelemente auch als Verdrängungselemente ausgeführt sein, die sich beim Einschieben in das Profil auf das Maß der Nut abscheren. Solche Art Federelemente sind nur einmal verwendbar.

In Weiterbildung der Erfindung weisen die Referenzzapfen Verdrängungsrippen zur besseren Verbindung mit der Elektronikkarte auf, welche abhängig vom Bohrlochdurchmesser der Elektronikkarte beim Zusammensetzen abgeschert werden. Damit können die Toleranzen der Bohrlochdurchmesser der Elektronikkarten aufgefangen werden, um eine spielfreie Verbindung zur Elektronikkarte und zwischen den Elektronikkarten herzustellen. Die Anzahl der Referenzzapfen des Funktionselements kann variieren.

In Weiterbildung der Erfindung sind dritte Referenzzapfen auf der anderen Flachseite vorgesehen zur Halterung einer weiteren Elektronikkarte parallel zu den verbundenen Elektronikkarten. Die weitere Elektronikkarte kann zusätzlich in einer separaten Profilnut relativ zur den ersten Elektronikkarten positioniert sein.

In einer weiteren Ausführungsform weist das Funktionselement eine mittige Ausnehmung auf zur Positionierung eines elektrischen Verbinders für die Elektronikkarten. Diese Verbindung kann durch ein einfaches Stecker- und Buchsenteil gewährleistet sein, wobei das Steckerteil eine einfache Stiftleiste sein kann. Eine mechanische Verriegelung von Stecker und Buchse ist nicht notwendig.

Zu Stabilisierung und Verstärkung des Funktionselements weist dieses Verstärkungsrippen auf wenigstens einer der Flachseiten des Funktionselements auf, die vorteilhafterweise entsprechend den auftretenden Kräften designt sind.

Das Funktionselement ist in kostengünstiger Weise als Spritzgussteil bevorzugt aus Kunststoff ausgebildet. Als Spritzgussteil ist es bezüglich Abmessungen mit sehr geringen Toleranzen behaftet. Es ist auch denkbar, dass das Funktionselement aus anderen Materialien anders hergestellt ist, z. B. als Metallguss oder aus Keramik.

Für eine gezielte Temperaturabhängigkeit ist das Verhältnis des Abstands der Referenzzapfen auf einem Funktionselement in Längsrichtung gesehen zu dem Abstand der Referenzbohrungen auf einer Elektronikkarte in Längsrichtung gesehen, derart gewählt, dass die Längenausdehnung der Elektronikkartenkette, bestehend aus den über die Funktionselemente miteinander verbundenen Elektronikkarten, in etwa der Längenausdehnung des Gehäuses entspricht. Dabei wird also das eigentlich störende Temperaturverhalten des Kunststoffs des Funktionselements ausgenutzt, um den Unterschied in den Temperaturverhalten von Gehäuse und Eektronikkartenmaterial auszugleichen.

Das Funktionselement kann wenigstens eine der benachbarten Elektronikkarten teilweise oder vollständig umschließen.

Im Folgenden wird die Erfindung anhand von Ausführungsbeispielen unter Bezugnahme auf die Zeichnung im Einzelnen erläutert. In der Zeichnung zeigen:
- Fig. 1: eine schematische Darstellung eines erfindungsgemäßen Lichtgitters;
- Fig. 2: eine Darstellung der Verbindung zweier benachbarter Elektronikkarten;
- Fig. 3: eine Draufsicht auf ein Funktionselement;
- Fig. 4: eine Stirnansicht des Gehäuseprofils mit eingesetzter Elektronikkarte und Funktionselement.

Ein erfindungsgemäßer optoelektronischer Sensor ist in diesem Ausführungsbeispiel als Lichtgitter 10 ausgebildet. Das Lichtgitter 10 weist ein Sendergehäuse 12 und ein Empfängergehäuse 14 auf, die einerseits eine in Längsrichtung 16 (im Folgenden auch z-Richtung) angeordnete Reihe von Lichtsendern 18 aufweisen bzw. eine in Längsrichtung angeordnete Reihe von Empfängern 20. Jedem Lichtsender 18 ist gegenüberliegend ein Empfänger 20 zugeordnet, so dass zwischen Sender-Empfänger-Paaren jeweils ein Lichtstrahl 22 liegt. Die Lichtstrahlen 22 definieren in ihrer Gesamtheit ein ebenes Überwachungsfeld, das daraufhin überwacht wird, ob eine oder mehrere der Lichtstrahlen 22 von einem nicht dargestellten Objekt unterbrochen werden. Eine solche Unterbrechung wird in einer Empfängerelektronik 24 ausgewertet und ein entsprechendes Schaltsignal an einem Ausgang 26 ausgegeben. Senderseitig ist eine Ansteuerelektronik 28 zur Ansteuerung der Lichtsender 18 vorgesehen.

Die Lichtstrahlen 22 haben einen möglichst gleichmäßigen genauen Abstand, der auch als Rastermaß bezeichnet wird.

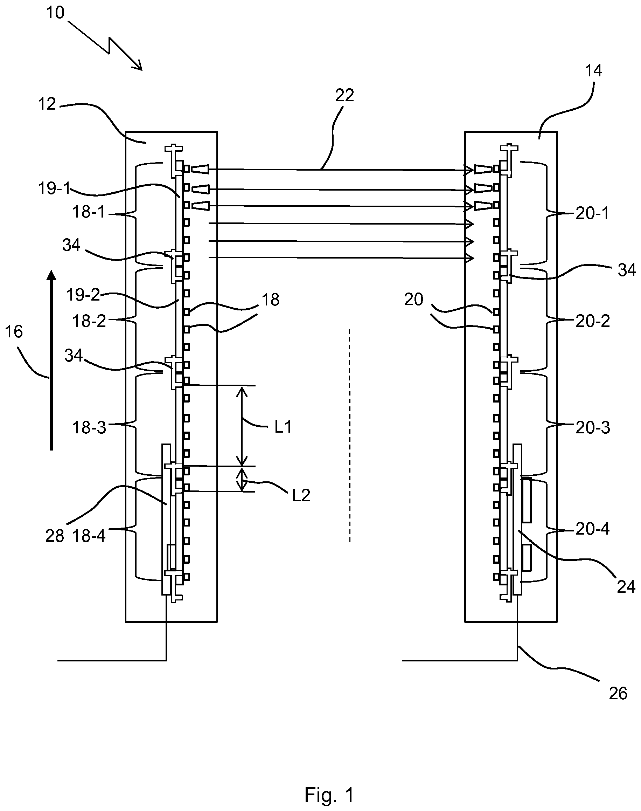

Die Reihe der Lichtsender 18 bzw. die Reihe der Lichtempfänger 20 ist gebildet durch einzelne, aneinandergereihte Module 18-1 bis 18-4 bzw. 20-1 bis 20-4. Mit diesem modulartigen Aufbau lassen sich verschieden lange Reihen gleicher Module aufbauen für unterschiedlich große Lichtgitter 10. Jedes einzelne Modul besteht aus einer Elektronikkarte 19, auf der wenigstens eine bestimmte Anzahl Lichtsender 18 bzw. Empfänger 20 angeordnet sind. In dem in Fig. 1 dargestellten Beispiel sind jeweils sechs Lichtsender 18 bzw. Empfänger 20 beispielhaft dargestellt. Benachbarte Module, beispielsweise 18-1 und 18-2, müssen einerseits mechanisch und andererseits elektrisch miteinander verbunden werden. Insbesondere die mechanische Verbindung, Positionierung und Halterung ist Gegenstand dieser Erfindung. Denn nur wenn die Verbindung von Modul zu Modul exakt ist und die Module im Gehäuse 12, 14 genau positioniert und gehalten sind, kann ein genaues Rastermaß über die Länge des Lichtgitters 10 eingehalten werden.

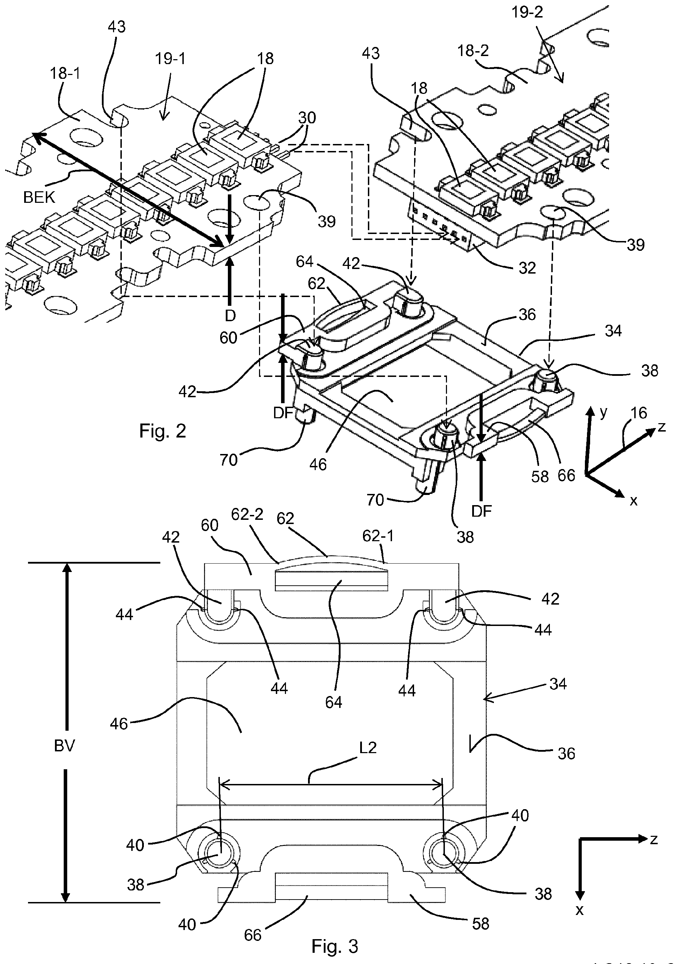

Die Verbindung von beispielsweise den Modulen 18-1 und 18-2 ist beispielhaft im Detail in Fig. 2 dargestellt.

Die elektrische Verbindung erfolgt über eine einfache Stecker-Buchse Verbindung. Dazu ist an der Elektronikkarte 19-1 des Moduls 18-1 ein Stecker angeordnet, von dem in der Fig. 2 lediglich die Steckerstifte 30 erkennbar sind und an der Elektronikkarte 19-2 des Moduls 18-2 ist eine entsprechende Buchsenleiste 32 angeordnet, zur Aufnahme der Steckerstifte 30.

Die mechanische Verbindung erfolgt über ein Funktionselement 34, das das wesentliche Teil der Erfindung darstellt. Das Funktionselement 34 ist im Wesentlichen flächig ausgebildet, wobei auf einer Flachseite 36, die in der Ansicht der Fig. 2 die Oberseite bildet, die Elektronikkarten 19-1 und 19-2 aufliegen.

Zusätzlich weist das Funktionselement 34 zwei erste Referenzzapfen 38 auf, die im Querschnitt rund ausgebildet sind und die bei der Montage in auf den Elektronikkarten 19-1 und 19-2 vorgesehenen erste Referenzbohrungen 39 eingeführt werden. Zusätzlich weist jeder Referenzzapfen 38 Verdrängungsrippen 40 auf, die bei der Montage abgeschert werden. Des Weiteren weist das Funktionselement 34 zweite Referenzzapfen 42 auf, die im Querschnitt lang gezogen und an einer Seite halbrund ausgebildet sind. Die zweiten Referenzzapfen 42 weisen ebenfalls Verdrängungsrippen 44 auf. Die ersten Referenzzapfen 38 dienen für die genaue Positionierung der Elektronikkarten 19-1 und 19-2 und die zweiten Referenzzapfen 42 dienen für eine stabile Verbindung zwischen Funktionselement 34 und Elektronikkarte 19-1 bzw. 19-2. Dabei werden die zweiten Referenzzapfen 42 in halboffene zweite Referenzbohrungen 43 aufgenommen.

Im Innenbereich des Funktionselements 34 weist das Funktionselement 34 eine größere rechteckige Ausnehmung 46 auf, in die beim Zusammenbau die Stecker-Buchse-Verbindung angeordnet ist. Die Montage und Verbindung zweier Elektronikkarten 19-1 und 19-2 über das Funktionselement 34 erfolgt in zwei Schritten, wobei im ersten Schritt die elektrische Verbindung hergestellt wird und danach die so verbundenen Elektronikkarten 19-1 und 19-2 mit dem Funktionselement 34 verbunden werden.

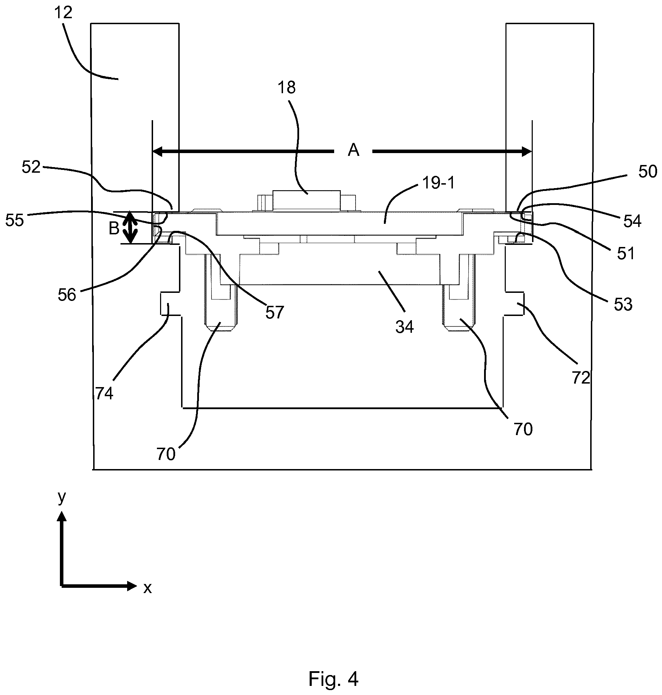

Die so über die Funktionselemente 34 verbundenen Elektronikkarten 19 werden dann bei der weiteren Montage des Lichtgitters in das Gehäuse 12 bzw. 14 eingeführt. Ein solches Gehäuse ist im Querschnitt in Fig. 4 dargestellt (hier beispielhaft das Sendergehäuse 12, wobei das Empfängergehäuse 14 identisch aufgebaut ist). In dieser Darstellung ist nur das reine Gehäuse 12 und eine eingesetzte Elektronikkarte 19-1 mit einem Lichtsender 18 und einem Funktionselement 34 dargestellt. Andere wesentliche Komponenten des Lichtgitters, wie beispielsweise eine Sendeoptik (oberhalb der Sender 18) oder eine die offene Seite des Profils abschließende Frontscheibe oder elektrische Leitungen und Stecker, sind der Einfachheit halber nicht dargestellt, da sie für das weitere Verständnis keine Rolle spielen.

Das Gehäuse 12 ist vorzugsweise als Aluminiumprofil ausgebildet und weist innenseitig zwei gegenüberliegende Nuten 50 und 52 auf. Das Gehäuse 12 könnte auch aus Kunststoff bestehen. Die beiden Nuten 50 und 52 dienen der Aufnahme der Elektronikkartenkette, die aus den aneinandergereihten und über die Funktionselemente 34 verbundenen Module 18-1 bis 18-4 besteht.

In diesem Ausführungsbeispiel haben die Nuten 50 und 52 eine Breite B und einen Abstand A zueinander, wobei der Abstand A von einem Nutboden 54 der einen Nut 50 zum Nutboden 56 der anderen Nut 52 definiert ist. Die Elektronikkarten 19 haben eine Breite BEK und eine Dicke D, wobei die Breite BEK etwas kleiner als der Abstand A und die Dicke D etwas kleiner als die Nutbreite B ist. Die Nutbreite B ist definiert als der Abstand der parallelen Nutwände 51 und 53 der Nut 50 einerseits und der Nutwände 55 und 57 der Nut 52 andererseits. Die Elektronikkarten 19 alleine würden also damit mit etwas Spiel in den Nuten 50 und 52 gehalten sein. Andere, nämlich kleinere Abmessungen der Elektronikkarten sind denkbar. Die hier beispielhaft genannten sind aber vorteilhaft, denn dann sind die Elektronikkarten schon alleine wegen ihrer Größe grob, nämlich mit Spiel, in den Nuten geführt. Die exakte Positionierung erfolgt schließlich über die Funktionselemente 34.

Das Funktionselement 34 weist auf der genannten Oberseite 36 neben den Referenzzapfen 38 und 42 noch an beiden Längsseiten, die parallel zur Längsrichtung 16 verlaufen, einen ersten und zweiten Fortsatz 58 und 60 auf. Zwischen den Fortsätzen sind einerseits die Elektronikkarten 19-1 und 19-2 seitlich geführt und andererseits weisen diese Fortsätze 58 und 60 Federelemente auf.

Der zweite Fortsatz 60 weist dabei ein erstes Federelement 62 auf, das durch einen Bogen gebildet ist, der an seinen Enden 62-1 und 62-2 befestigt ist und dessen Wölbung sich leicht nach außen wölbt, so dass die Wölbung leicht über die Breite BV des Funktionselements hinausragt. In analoger Weise ist an dem zweiten Fortsatz 60 ein zweites Federelement 64 vorgesehen, das allerdings anders ausgerichtet ist, dessen Wölbung nämlich um 90° um die Längsrichtung 16 verdreht ist und somit leicht über die Dicke DF des Fortsatzes 60 übersteht, wie in Fig. 2 angedeutet ist. Der erste Fortsatz 58 weist wie der zweite Fortsatz 60 ein solches zweites Federelement 66 auf. Die Wölbung der zweiten Federelemente 64 und 66 steht in der in Fig. 2 dargestellten Ausrichtung nach unten über die Fortsätze hinaus. Die Dicke DF der Fortsätze ist etwas kleiner als die Dicke D der Elektronikkarten 19.

Wird nun die Elektronikartenkette mit den Modulen 18 und den Funktionselementen 34 in das Gehäuse 12 eingeschoben, so kommen die Elektronikkarten 19 mit ihren Oberseiten (Fig. 2 und 4), die ja höher sind als die Referenzzapfen, an die Nutwände 51 und 55 zur Anlage und werden durch die Federelemente 64 und 66, die sich mit ihren Wölbungen gegen die anderen Nutwände 53 und 57 abstützen, vorgespannt gehalten. Damit ist die Elektronikkartenkette in y-Richtung (Fig. 4) fixiert und ohne Spiel und mit Vorspannung gehalten.

In x-Richtung (Fig. 4) kommen die Funktionselemente 34 mit ihrer Längsseite des ersten Fortsatzes 66 zur Anlage an den Nutboden 54 der Nut 50. In der anderen Nut 52 kommt das Federelement 62 mit seiner Wölbung gegen den Nutboden 56 zur Anlage und fixiert somit das Funktionselement 34 ohne Spiel und mit Vorspannung in x-Richtung.

Insgesamt ist damit eine exakte Positionierung, Ausrichtung und spielfreie Fixierung in der x-y Ebene und damit senkrecht zur Längsrichtung (z-Richtung) erhalten.

Damit bilden die Funktionselemente 34 das zentrale Trägersystem für die Elektronikkartenkette in der Profilnut. Kontakt mit den Nutwänden und Nutböden haben lediglich die Oberseite der Elektronikkarten und punktuell die Wölbungen der Federelemente.

Damit auch die äußeren Module (in Fig. 1 die letzten Module 18-1 bzw. 20-1 und 18-4 bzw. 20-4 der Reihe) über die Funktionselemente 34 an ihren Enden gehalten werden, sind auch an den beiden Enden der Reihen Funktionselemente 34 angeordnet, obwohl dort kein weiteres Modul mit dem letzten Modul mehr verbunden werden muss. Diese Verbidungselemente an den Enden haben daher nur die Aufgabe der Halterung in den Nuten 50 und 52.

In z-Richtung, also in Längsrichtung, ist die Elektronikkartenkette in nicht dargestellter Weise über beispielsweise Endkappen für das Gehäuseprofil 12 bzw. 14 fixiert gehalten.

Das Funktionselement 34 ist bevorzugt als Spritzgussteil aus Kunststoff ausgebildet. Da die Materialeigenschaften von Aluminium des Gehäuses und von FR4 der Elektronikkarten hinsichtlich Längenausdehnung ähnlich sind, verhalten sich das Aluprofil und die Kette aus Elektronikkarten plus Verbinder bei Temperaturänderung ebenfalls ähnlich. Da sich FR4 Material minimal weniger ausdehnt als Aluminium, und Kunststoff wiederum deutlich mehr, kann über ein Verhältnis L1/L2, wobei L1 der Abstand der ersten bzw. der zweiten Referenzbohrungen 39 bzw. 43 auf einer Elektronikkarte (Fig. 1) ist und L2 der Abstand der ersten bzw. zweiten Referenzzapfen 38 bzw. 42, das Temperaturausdehnungsverhalten der gesamten Elektronikkartenkette so beeinflusst werden, dass dieses Verhalten dem des Gehäuses 12 angeglichen ist. Damit ist die Ausdehnungsdifferenz weitgehend zu Null kompensiert. Der Längenunterschied zwischen der gesamten Kette und dem Gehäuse wird dadurch aufgehoben bzw. deutlich reduziert.

In einer Ausführungsform weist das Funktionselement an der Unterseite (gemäß Fig. 2 und 4) dritte Referenzzapfen 70 auf. Diese dritten Referenzzapfen 70 dienen zur Halterung einer weiteren Elektronikkarte (nicht dargestellt), die selbst wiederum in weiteren Nuten 72 und 74 grob geführt sein kann. Da diese weitere Elektronikkarte keine optischen Elemente trägt und demnach auch nicht genau positioniert sein muss, entfallen dort die hohen Positionsanforderungen, so dass eine grobe Führung in den Nuten 72 und 74 ausreicht.

Abschließend seien der Vollständigkeit halber noch einmal wesentliche Funktionen und Vorteile des Funktionselements 34 aufgezählt. Das Funktionselement 34
- verbindet die Elektronikkarten hochgenau, so dass über die hochgenauen Referenzbohrungen 39, 43 die Sende- und Empfangselemente 18, 22 hochgenau das Rastermaß erfüllen;
- dient als Zugentlastung der elektrischen Verbindung 30, 32;
- positioniert die Elektronikkarten in x-y Richtung gegenüber dem Gehäuse hochgenau und positioniert hochgenau benachbarte Elektronikkarten in z-Richtung relativ zueinander, damit das Rasermaß eingehalten ist;
- kompensiert die Temperaturausdehnung.

## Patentansprüche

1. Optoelektronischer Sensor, insbesondere Lichtgitter (10), mit wenigstens zwei in einer Längsrichtung (16, z-Richtung) hintereinander anzuordnenden Elektronikkarten (19, 19-x), auf denen mehrere Lichtsender (18) und/oder Lichtempfänger (20) in Reihe angeordnet sind, wobei die Elektronikkarten (19-1, 19-2) durch ein Funktionselement (34) in Sollposition zueinander fixiert sind und die Elektronikkarten (19-1, 19-2) in einem Gehäuse (12) gehalten sind, **dadurch gekennzeichnet, dass** das Gehäuse (12) als Profil ausgebildet ist und die Elektronikkarten (19-1, 19-2) in in Längsrichtung (16, z-Richtung) verlaufenden, gegenüberliegenden Nuten (50, 52) des Profils (12) über die Funktionselemente (34) gehalten sind, so dass die Funktionselemente (34) die Elektronikkarten (19-1, 19-2) senkrecht zur Längsrichtung (16, z-Richtung) in zwei orthogonalen Richtungen (x-Richtung, y-Richtung) lagefest positionierenwobei
das Funktionselement (34) wenigstens ein erstes Federelement (62) und wenigstens ein zweites Federelement (64, 66) aufweist, so dass das Funktionselement (34) durch federelastische Anlage des zweiten Federelements (64, 66) zwischen Nutwänden (51, 53; 55, 57) in die eine der orthogonalen Richtungen (y-Richtung) einerseits und durch federelastische Anlage des ersten Federelements (62) zwischen Nutböden (54, 56) andererseits in die andere orthogonale Richtung (x-Richtung) senkrecht zur Längsrichtung (z-Richtung) fixiert, aber in Längsrichtung (z-Richtung) verschiebbar gehalten ist.

2. Sensor nach einem der vorhergehenden Ansprüche, **dadurch gekennzeichnet, dass** das Funktionselement flächig ausgebildet ist und flächig an den Elektronikkarten anliegt und dass erste und zweite, von einer der Flachseiten abstehende Referenzzapfen vorgesehen sind zur lagefesten Verbindung des Funktionselements mit den Elektronikkarten.

3. Sensor nach Anspruch 2, **dadurch gekennzeichnet, dass** die Elektronikkarten erste und zweite Referenzbohrungen aufweisen zur Aufnahme der Referenzzapfen.

4. Sensor nach einem der vorhergehenden Ansprüche 2 oder 3, **dadurch gekennzeichnet, dass** die Referenzzapfen Verdrängungsrippen aufweisen zur kraftschlüssigen Verbindung des Funktionselements mit den Elektronikkarten.

5. Sensor nach einem der vorhergehenden Ansprüche, **dadurch gekennzeichnet, dass** dritte Zapfen auf der anderen Flachseite vorgesehen sind zur Halterung einer weiteren Elektronikkarte parallel zu den verbundenen Elektronikkarten.

6. Sensor nach einem der vorhergehenden Ansprüche, **dadurch gekennzeichnet, dass** das Funktionselement eine mittige Ausnehmung aufweist zur Positionierung eines elektrischen Verbinders für die Elektronikkarten.

7. Sensor nach einem der vorhergehenden Ansprüche, **dadurch gekennzeichnet, dass** Verstärkungsrippen auf wenigstens einer der Flachseiten des Funktionselements vorgesehen sind.

8. Sensor nach einem der vorhergehenden Ansprüche, **dadurch gekennzeichnet, dass** das Funktionselement als Spritzgussteil aus Kunststoff ausgebildet ist.

9. Sensor nach einem der vorhergehenden Ansprüche, **dadurch gekennzeichnet, dass** das Verhältnis des Abstands der Referenzzapfen auf einem Funktionselement in Längsrichtung gesehen zu dem Abstand der Referenzbohrungen auf einer Elektronikkarte in Längsrichtung gesehen, derart gewählt ist, dass die Längenausdehnung der Elektronikkartenkette, bestehend aus den über die Funktionselemente miteinander verbundenen Elektronikkarten, in etwa der Längenausdehnung des Gehäuses entspricht.

## Claims

1. An optoelectronic sensor, in particular a light grid (10), having at least two circuit boards (19, 19-x) which are to be arranged one after the other in a longitudinal direction (16, z direction) and on which a plurality of light transmitters (18) and/or light receivers (20) are arranged in series, wherein the circuit boards (19-1, 19-2) are fixed in a desired position with respect to one another by a functional element (34), wherein the circuit boards (19-1, 19-2) are held in a housing (12), **characterized in that** the housing (12) is configured as a section and the circuit boards (19-1, 19-2) are held via the functional elements (34) in oppositely disposed grooves (50, 52) of the section (12) which extend in the longitudinal direction (16, z direction) so that the functional elements (34) position the circuit boards (19-1, 19-2) in a fixed position perpendicular (in the x-y plane) to the longitudinal direction (16, z direction), wherein the functional element (34) has at least one first spring element (62) and at least one second spring element (64, 66) so that the functional element (34) is fixed in the first orthogonal direction (y direction) between groove walls (51, 53; 55, 57) by the second spring element (64, 66) and in the orthogonal direction (x direction) fixed between groove bases (54, 56) by the first spring element (62), but is resiliently displaceably held in the longitudinal direction (z dierection).

2. A sensor in accordance with claim 1, **characterized in that** the functional element is flat and has flat contact to the circuit boards, and **in that** first and second reference spigots are provided which project from one of the flat sides for the positionally fixed connection of the functional element to the circuit board.

3. A sensor in accordance with claim 2, **characterized in that** the circuit boards have first and second reference bores for receiving the reference spigots.

4. A sensor in accordance with claim 2 or 3, **characterized in that** the reference spigots have displacement ribs for a force-transmitting connection of the functional element to a circuit board.

5. A sensor in accordance with any preceding claim, **characterized in that** third spigots are provided on the other of the flat sides for holding a further circuit board in parallel with a connected circuit board.

6. A sensor in accordance with any preceding claim, **characterized in that** the functional element has a central cut-out for the positioning of an electrical connector for a circuit board.

7. A sensor in accordance with any preceding claim, **characterized in that** reinforcement ribs are provided at at least one of the flat sides of the functional element.

8. A sensor in accordance with any preceding claim, **characterized in that** each functional element is formed as an injection molded part from plastic.

9. A sensor in accordance with any preceding claim, **characterized in that** a ratio of the spacing of longitudinally spaced reference spigots on a functional element to a spacing of the longitudinally spaced reference bores on first and second circuit boards respectively engaging the longitudinally spaced reference spigots is selected such that the longitudinal expansion of a circuit board chain comprising a plurality of circuit boards connected to one another via functional elements approximately corresponds to a longitudinal expansion of the housing.

## Revendications

1. Capteur optoélectronique, en particulier barrière lumineuse (10), comprenant au moins deux cartes électroniques (19, 19-x) à agencer l'une derrière l'autre dans une direction longitudinale (16, direction-z), sur lesquelles sont agencés en rangées plusieurs émetteurs de lumière (18) et/ou plusieurs récepteurs de lumière (20), dans lequel les cartes électroniques (19-1, 19-2) sont fixées dans une position de consigne les unes par rapport aux autres au moyen d'un élément fonctionnel (34) et les cartes électroniques (19-1, 19-2) sont retenues dans un boîtier (12), **caractérisé en ce que** le boîtier (12) est réalisé sous forme de profilé et les cartes électroniques (19-1, 19-2) sont retenues dans des gorges opposées (50, 52), s'étendant en direction longitudinale (16, direction-z), du profilé (12) au moyen des éléments fonctionnels (34), de telle façon que les éléments fonctionnels (34) positionnent les cartes électroniques (19-1, 19-2) fermement en situation perpendiculairement à la direction longitudinale (16, direction-z) dans deux directions orthogonales (direction-x, direction-y), dans lequel l'élément fonctionnel (34) comprend au moins un premier élément à ressort (62) et au moins un second élément à ressort (64, 66), de telle sorte que l'élément fonctionnel (34) est fixé d'une part par appui élastique du second élément à ressort (64, 66) entre des parois de gorges (51, 53 ; 55, 57) dans l'une des directions orthogonales (direction-y) et d'autre part par appui élastique du premier élément à ressort (62) entre des fonds de gorges (64, 56) dans l'autre direction orthogonale (direction-x) perpendiculaire à la direction longitudinale (direction-z), mais est retenu avec possibilité de translation dans la direction longitudinale (direction-z).

2. Capteur selon l'une des revendications précédentes, **caractérisé en ce que** l'élément fonctionnel est réalisé sous forme surfacique et s'applique à plat contre les cartes électroniques, et **en ce qu'**il est prévu des premiers et des seconds tenons de référence en saillie de l'un des côtés plats pour la liaison de l'élément fonctionnel avec les cartes électroniques.

3. Capteur selon la revendication 2, **caractérisé en ce que** les cartes électroniques comprennent des premiers et des seconds perçages de référence pour la réception des tenons de référence.

4. Capteur selon l'une des revendications précédentes 2 ou 3, **caractérisé en ce que** les tenons de référence comprennent des nervures à refoulement pour la liaison en coopération de forces de l'élément fonctionnel avec les cartes électroniques.

5. Capteur selon l'une des revendications précédentes, **caractérisé en ce qu'**il est prévu des troisièmes tenons sur l'autre côté plat pour retenir une autre carte électronique parallèle aux cartes électroniques reliées.

6. Capteur selon l'une des revendications précédentes, **caractérisé en ce que** l'élément fonctionnel comporte un évidement médian pour le positionnement d'un connecteur électrique pour les cartes électroniques.

7. Capteur selon l'une des revendications précédentes, **caractérisé en ce que** des nervures de renforcement sont prévues sur l'un au moins des côtés plats de l'élément fonctionnel.

8. Capteur selon l'une des revendications précédentes, **caractérisé en ce que** l'élément fonctionnel est réalisé en matière plastique sous forme d'une pièce coulée par injection.

9. Capteur selon l'une des revendications précédentes, **caractérisé en ce que** le rapport de la distance des tenons de référence sur un élément fonctionnel, vu en direction longitudinale, sur la distance des perçages de référence sur une carte électronique, vue en direction longitudinale, est choisi de telle façon que l'extension longitudinale de la chaîne de cartes électroniques, constituée des cartes électroniques reliées les unes aux autres au moyen des éléments fonctionnels, correspond approximativement à l'extension longitudinale du boîtier.
